# EUROPEAN PATENT SPECIFICATION

(11) **EP 0 665 468 B1**
(45) Date of publication and mention of the grant of the patent: **19.04.2000**
(21) Application number: 94309909.3
(22) Date of filing: 29.12.1994
(51) Int. Cl.: G03F 7/085

(54) **Staining inhibitor for photopolymerizable compositions containing a tetrazole**
Ein Tetrazol enthaltender Verfärbungsinhibitor für photopolymerisierbare Zusammensetzungen
Agent anti-tache pour des compositions photopolymérisables contenant un tétrazole

(30) Priority: 30.12.1993 GB 9326553
(43) Date of publication of application: 02.08.1995
(73) Proprietor: MacDermid Imaging Technology Inc., Waterbury, CT 06702 (US)
(72) Inventor: Mayes, Richard Thomas, Newark, Delaware 19711 (US)
(74) Representative: De Minvielle-Devaux, Ian Benedict Peter

(56) References cited:
- US-A- 4 629 679
- US-A- 4 741 987
- PATENT ABSTRACTS OF JAPAN vol. 08, no. 151 (P-286)13 July 1984 & JP-A-59 048 752 (HITACHI KASEI KOGYO KK) 21 March 1984
- PATENT ABSTRACTS OF JAPAN vol. 8, no. 254 (P-315)21 November 1984 & JP-A-59 125 726 (MITSUBISHI RAYON KK) 20 July 1984
- PATENT ABSTRACTS OF JAPAN vol. 13, no. 540 (P-969)5 December 1989 & JP-A-01 223 444 (TOYOBO CO LTD.) 6 September 1989

## Description

This invention relates to an improved photopolymerizable composition for use in plating and etching processes used in the manufacture of printed circuit boards and chemical milling processes.

Many examples of photopolymerizable compositions which make use of adhesion promoters are known in the art. These adhesion promoters may be added to the compositions as well as added to a substrate prior to lamination of the substrate with a photoresist. These adhesion promoters work quite well, however, formulations comprising adhesion promoters cause the formulations to have narrow process windows with respect to hold time after lamination.

When a copper clad laminate is coated with formulations containing mercapto, triazole, imidazole etc., it is a common problem that staining of the copper cladding will occur with hold times of as little as one day. Staining of the copper cladding causes inhibition of etching which causing shorts in print and etch process. In plating processes staining can be difficult to remove using traditional cleaners resulting in areas of non-plating causing open circuits in final product made therefrom. JP-A-53048752 discloses photopolymerizable compositions comprising monomer, a resin and at least on compound selected from a group of imidazole, thiazole, tetrazole and their derivatives.

The instant invention according to claim 1 relates to a stain resistant photopolymerizable composition comprising an adhesion promoting system comprising a tetrazole in combination with a benzotrinzole stain prone adhesion promoter. The stain resistant photopolymerizable composition additionally comprises a polymeric binder, a multifunctional monomer, a free radical photoinitiator and optionally a thermal addition inhibitor.

This invention provides, in particular, a photopolymerizable composition which employs tetrazoles in combination with stain prone adhesion promoters, selected from benzotriazoles, as an adhesion promoting system. In addition, the composition contains a polymeric binder, a multifunctional monomer, a free radical photoinitiator, and optionally a thermal addition inhibitor. Additionally, the photopolymerizable composition may comprise dyes, plasticizers, and other additives to enhance the physical and chemical properties of the composition.

Amongst the tetrazoles useful in this invention are substituted tetrazoles wherein the tetrazole is substituted with a group selected from the group consisting of aryl, mercapto, alkyl, amine, substituted amine and hydroxy groups. Amongst the substituted tetrazoles in this invention are 5-aminotetrazole monohydrate and 5-phenyltetrazole.

The substituted tetrazoles are present in the photopolymerizable composition from about 0.001 to 1% by weight, preferably from about 0.01 to 0.5%, more preferably from about 0.01 to 0.1%.

Stain prone adhesion promoters are known to those skilled in the art and are generally known as those compounds which are used to promote adhesion of photopolymeric material to conductive substrates while exhibiting the tendency to form stains which may retard etching in subsequent processing steps. In general, the prone adhesion promoter is at least one compound chosen from the group consisting of benzotriazole, derivatives thereof and salts thereof. The. term "derivatives thereof" as used herein means those compounds in which a hydrogen atom or atoms are substituted with at least one alkyl group, aryl group, nitro group, halogen, amino group, hydroxyl group, carboxyl group or the like or those in which the benzene ring has been substituted by a naphthalene ring. The term "salts thereof' means acid salts, such as hydrochlorides, acetates, etc., of said compounds, amine salts, etc.

Preferred examples of these compounds are benzotriazole, benzotriazole hydrochloride, 1-chlorobenzotriazole, hydroxybenzotriazole, naphthotriazole, methylbenzotriazole and amine salts, etc., thereof Among the salts, hydrochlorides are preferred because of their ease of preparation. A noticeable effect of addition of these compounds can be obtained from the compound content of about 0.001% by weight or more in the photosensitive resin composition, but preferably said compound is added in an amount of about 0.01 to 3% by weight in the photosensitive resin composition. Benzotriazole adhesion promoters prone to cause staining are disclosed in U.S. Patent No. 4,438,190, incorporated herein by reference.

The other ingredients are identical to those disclosed in the patent literature namely, U.S. Patent No. 3,953,309 and U.S. Patent No. 3,887,450.

The photopolymerizable compositions of this invention are composed of (1) from about 10 to 60 parts by weight of a multifunctional monomer, (2) from about 40 to 90 parts by weight of the aforesaid binding agent, (3) from about 0.001 to 10 parts by weight of a conventional free-radical initiator, and (4) from about 0.001 to 5 parts by weight of a conventional thermal addition polymerization inhibitor. Additionally, the compositions may contain suitable dyes and pigments and other additives, such as plasticizers and adhesion promoters, as may be necessary to enhance the physical and chemical properties of the photo-polymerizable composition.

The multifunctional monomer is typically a conventional addition polymerizable ethylenically unsaturated compound. The ethylenically unsaturated compound must contain at least one terminal ethylenic group (CH₂=C<) having a boiling point of about 100° C. at atmospheric pressure and be capable of forming a high polymer by free-radical photo-initiated, chain propagating addition polymerization. Such compounds are disclosed in U.S. Patent No. 2,760,863.

Preferably, the compounds are non-gaseous at 20° C. and atmospheric pressure, have 1 to 4 or more terminal ethylenic groups, preferably 2 to 3 or more, and exhibit plasticization of the thermoplastic polymeric binder. Suitable compounds, which may be used alone or in combination, include an alkylene or a polyalkylene glycol diacrylate prepared from the alkylene glycols having 2 to 15 carbons or polyalkylene ether glycols of 1 to 10 ether linkages.

Because of their generally rapid rate of insolubilization on exposure, presumably due to a relatively rapid establishment of a network polymer structure, an outstanding class of the low molecular weight addition polymerizable components are those having a plurality of addition polymerizable ethylenic linkages, particularly when present as terminal linkages, and especially those wherein at least one and preferably most of such linkages are conjugated with a doubly bonded carbon, including carbon doubly bonded to carbon and to such heteroatoms as nitrogen, oxygen, and sulfur. Preferably, the low molecular weight addition polymerizable components are such materials wherein the ethylenically unsaturated groups, especially the vinylidene groups, are conjugated with ester or amide structures. The following specific compounds are further illustrative of this class: unsaturated esters of polyols, particularly such esters of the methylene carboxylic acids, e.g., ethylene diacrylate; diethylene glycol diacrylate; glycerol diacrylate; glycerol triacrylate; ethylene dimethacrylate; 1,3-propylene dimethacrylate; 1,2,4,-butane triol trimethacrylate; 1,4-benzene-diol dimethacrylate; pentaerythritol tetramethacrylate; 1,3-propanediol diacrylate; 1,5-pentane-diol dimethyacrylate; the bis-acrylates and methacrylates of polyethylene glycols of molecular weight 200-500, and the like; unsaturated amides, particularly those of the methylene carboxylic acids, and especially those of alpha, omega-diamines and oxygen-interrupted omega-diamines, such as methylene bisacrylamide; methylene bis-methacrylamide; 1,6-hexamethylene bisacrylamide; diethylene triamine tris-methacrylamide; bis(methacrylamidopropoxy)ethane; beta-methacrylamidoethyl methacrylate; N - [(beta-hydroxyettayl-oxy) ethyl] acrylamide; vinyl esters such as divinyl succinate, divinyl adipate, divinyl phthalate, divinyl terephthalate, divinyl benzene-1 ,3-disulfonate, and divinyl butane-1,4-disulfonate; and unsaturated aldehydes, such as sorbaldehyde (hexadienal).

The preferred monomeric compounds are di- or poly- functional. Monofunctional monomers can also be used in combination with multifunctional monomers where the total functionality of the monomers used therein is 2 or greater. The amount of monomer added varies with the particular thermoplastic polymer.

The styrene-type constituent of the polymeric binder may have the general formula: 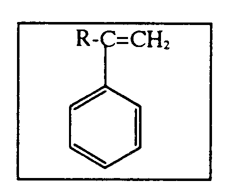 wherein R is hydrogen or an alkyl group having from 1 to 6 carbon atoms or a halo group. The benzene ring may be ring substituted with functional groups, such as nitro, alkoxy, acyl, carboxyl, sulpho, hydroxyl or halo. From 1 to 5 benzene substituents may be present, preferably, the substituents are a single alkyl group such as a methyl or t-butyl group. Most preferred of these compounds are styrene, alpha-methyl styrene, paramethyl styrene and para-t-butyl styrene.

The vinyl monomer constituent of the polymeric binder is non-acidic and has the general formula: 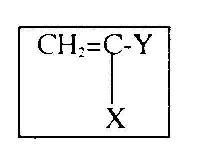 wherein, X is hydrogen, Y is OOCR₁, OR₁, OCR₁, COOR₁, CN, CH₂=CH, CONR₃R₄ or Cl; when X is methyl, Y is COOR₁, CN, CH₂=CH, or CONR₃R₄; and when X is Cl, Y is Cl; and wherein R₁ and R₂ is an alkyl group having from 1 to 12 carbon atoms, a phenyl on a benzyl group and R₃ and R₄ are hydrogen, an alkyl group having 1 to 12 carbon atoms or a benzyl group.

Examples of these vinyl monomers are vinyl acetate, vinyl butyrate, vinyl benzoate, vinyl chloride, vinylidene chloride, methyl methacrylate and methylacrylate, acrylonitrile and methacrylonitrile, methacrylamide, and alkyl substituted acrylamides, vinyl methyl ketone, vinyl propyl ketone, vinyl methyl ethyl, vinyl ethyl ether and vinyl hexyl ether.

The second comonomer may be one or more unsaturated carboxyl containing monomers having from 3 to 15 carbon atoms, preferably, from 3 to 6. Most preferred compounds are acrylic acid and methacrylic acid, Other acids which may be used are cinnamic acid, crotonic acid, sorbic acid, itaconic acid, propiolic acid, maleic acid, fumaric acid, or the corresponding half esters or, where possible, the corresponding anhydride This invention is of particular utility when alkyl styrene maleate copolymers are used as the binding agent.

The ratio of the styrene or vinyl component to the acidic comonomer is selected so that the copolymer is soluble in the aqueous alkali medium. If the amount of the styrene or vinyl monomer is too high, the unexposed portion will not be sufficiently soluble; on the other hand, if the amount of styrene or vinyl monomer is too low, the exposed area will be tacky, swollen, or dissolved in the aqueous alkali.

Representative comonomer ratios are 70:30 to 85:15 for styrene-acrylic acid or methacrylic acid; 35:65 to 70:30 for styrene-monobutyl maleate and 70:30 to 95:5 for vinyl acetate-crotonic acid. The degree of polymerization of the binder copolymer is such that binder forms a non-tacky continuous film after exposure and development. Broadly, the molecular weight is from about 1,000 to about 500,000. The ranges for the copolymer ratios and the degree of polymerization for the particular binders can be readily ascertained by testing the solubility in the dilute alkali solution of representative polymers. This represents a molecular weight of from about 1,000 to about 500,000. As a convenient criteria, the binder copolymer should be such that a 40% solution in ketones or alcohols will have a viscosity of from 100 to 50,000 centipoise.

As noted, the resist from the practice of this invention is resistant to the usual plating and etching solutions. Most surprising is its resistance to the copper pyrophosphate solution which is used in pattern plating and has an extremely high alkalinity. Other solutions which leave the resist unaffected include ferric chloride, ammonium persulfate and chromic-sulfuric acid solutions.

The photoinitiators used in the compositions are preferably those activatable by actinic light and thermally inactive at 185° C. or below. These include the substituted or unsubstituted polynuclear quinones, such as 9,10-anthraquinone; 1-chloranthraquinone, 2-chloroanthraquinone, 2-methylanthraquinone; 2-ethylanthraquinone; 2-tert-butylanthraquinone; octamethylanthraquinone; 1,4-naphthaquinone; 9,10-phenonthraquinone; 1,2-benzanthraquinone; 2,3-ben-zanthraquinone; 2-methyl-1,4-naphthaquinone; 2,3-dichloronaphthaquinone 1,4-dimethylanthraquinone; 2,3-dimethylanthraquinone; 2-phenylanthraquinone; 2,3-diphenylanthraquinone; sodium salt of anthraquinone alpha sulfonic acid; 3-chloro-2-methylanthraquinone; rectenequinone; 7,8,9,10-tetrahydronaphthacenequinone; 1,2,3,4-tetrahydrobenz(a) anthracene-7, 12-dione.

The following photoinitiators, described in U.S. Patent 2,760,863, some of which may be thermally active at temperatures as low as 85° C., are also useful: vicinal ketaldonyl compounds, such as, diacetyl and benzil; alpha-ketaldonyl alcohols; such as, benzoin and pivaloin, acyloin ethers, e.g., benzoin methyl and ethyl ethers; alphahydrocarbon substituted aromatic acyloins; alpha-methylbenzoin, alpha-allylbenzoin; and alpha-phenylbenzion.

Silver persulfate is also useful as a free radical generating initiator activatable by actinic radiation. Certain aromatic ketones, e.g., benzophenone and 4,4'-bis-dialkylaminobenzophenones, are also useful.

Thermal polymerization inhibitors are also present in the preferred compositions. These include p-methoxy-phenol, hydroquinone, and alkyl and aryl-substituted hydroquinones and quinones, tert-butyl catechol, pyrogallol, copper resinate, naphthylamines, betanaphthol, cuprous chloride, 2,6-di-tert-butyl p-cresol, 2,2-methylenebis-(4-ethyl-6-t-butylphenol), phenothiazine, pyridine, nitrobenzene, dinitrobenzene, p-toluquinone, chloranil, aryl phosphites, and aryl alkyl phosphites.

If desired, the compositions may contain dyes and pigments. Suitable colorants will be compatible with the photosensitive compositions and not interfere appreciably with the photosensitivity of the composition. The following specific compounds are illustrative: Fuchsine (C. I. 42510); Auramine Base (C.I. 4100B); Calcocid Green S (C. I. 44090); Para Magenta (C.I. 42500); Tryparosan (C.I. 42505); New Magenta (C. I. 42520); Acid Violet RRH (C. I. 42425); Red Violet SRS (C.I. 42690); Nile Blue 2B (C. I. 51185); New Methylene Blue GG (C.I 51195); C. I. Basic Blue 20 (C. I. 42585); lodone Green (C.I. 42556); Night Green B (C. I. 42115); C. I. Direct Yellow 9 (C. I. 19540); C. I. Acid Yellow 17 (C. I. 18965); C. I. Acid Yellow 29 (C. I. 18900); Tartrazine (C. I. 19140); Supramine Yellow G (C. I. 19300); Buffalo Black 10B (C. I. 27790); Naphthalene Black 12R (C. I. 20350); Fast Black L (C. I. 51215); Ethyl Violet (C. I. 42600); Pontacyl Wool Blue BL (C. I. 50315); Pontacyl Wood Blue GL (C. I. 52320). (Numbers obtained from the second edition of Color Index).

The photopolymerizable elements are exposed to a source of actinic radiation. This may be through a half-tone image or a process transparency, e.g., a process negative or positive, stencil, or a mask. The exposure may also be through a continuous tone, negative or positive image. The exposure may be by the contact or projection method, with or without a cover sheet over the photopolymerizable layer or by projection using a cover sheet. These procedures are well known to those skilled in the art.

Since free-radical generating addition-polymerization initiators activatable by actinic radiation generally exhibit their maximum sensitivity in the ultraviolet range, the radiation source should furnish an effective amount of this radiation. Both point or broad radiation sources are effective. Such sources include carbon arcs, mercury-vapor arcs, fluorescent lamps with ultraviolet radiation-emitting phosphors, argon glow lamps, electronic flash units and photo- e.g., the carbonates and bicarbonates of the above amines; ammonium hydroxide and tetra-substituted ammonium hydroxides, e.g., tetramethyl-, tetraethyl-, trimethylbenzyl-, and trimethylphenylammonium hydroxides, sulfonium hydroxides, e.g., trimethyl-, diethylmethyl-, dimethylbenzylsulfonium hydroxides, and the basic soluble salts thereof, e.g., the carbonates, bicarbonates and sulfides, alkali metal phosphates and pyrophosphates, e.g., sodium and potassium triphosphates and sodium and potassium pyrophosphates, tetra-substituted (preferably wholly alkyl) phosphonium, arsonium, and stibonium hydroxide, e.g., tetramethylphosphonium hydroxide.

The photopolymerized compositions can generally be removed by immersion in heated aqueous solutions of strong alkalies or, if desired, in proprietary stripping formulas well known in the art.

This composition is very useful in alkaline etching processes, especially for fine line etching where excessive adhesion is required to prevent resist lifting.

The present invention may be further appreciated by reference to the following examples which are, of course, only representative of the present invention and in no way are meant to limit the present invention in any way to the particulars which are disclosed. Thus the following are given merely as non-limiting examples to further explain the present invention. All of the amounts and percentages are weight unless indicted otherwise.

The following examples demonstrate the useful combination of 5-aminotetrazole monohydrate and benzotriazole to aid in adhesion in an alkaline etching process. All formulations are blended, coated and dried on a polyester substrate, laminated to a copper clad substrate, held for 5 days, exposed using actinic radiation, developed in 1 wt% sodium carbonate monohydrate and etched in a ammoniacal etcher at an etchant pH of 8.2-8.8 and replenisher pH of 9.0-10.2. The etcher speed was adjusted to cleanly etch a 2 ounce copper panel leaving no extraneous copper. The performance of the resist is measured by reporting the percentage of lines remaining and the smallest resist lines remaining on the panel and the existence of extraneous copper remaining on the panel causing spacing violations or circuit shorts.

| Example 1 | | | | | |
|---|---|---|---|---|---|
| **Ingredient** | **Control** | **according to the invention Formulation A (wt%)** | **comparative Formulation B (wt%)** | **comparative Formulation C (wt%)** | **comparative Formulation D (wt%)** |
| SMA550 | 30.00 | 30.00 | 30.00 | 30.00 | 30.00 |
| TMPTA | 20.00 | 20.00 | 20.00 | 20.00 | 20.00 |
| Tributyl citrate | 2.00 | 2.00 | 2.00 | 2.00 | 2.00 |
| Butylated hydroxy toluene | 0.05 | 0.05 | 0.05 | 0.05 | 0.05 |
| Benzophenone | 2.0 | 2.0 | 2.0 | 2.0 | 2.0 |
| Michler's ketone | 0.12 | 0.12 | 0.12 | 0.12 | 0.12 |
| Benzotriazole | | 0.02 | | | |
| 2-mercaptobenzimidiazole | | | 0.02 | | |
| Reomet 42 | | | | 0.02 | |
| 3-mercaptotriazole | | | | | 0.02 |
| Crystal Violet Dye | 0.30 | 0.30 | 0.30 | 0.30 | 0.30 |
| Acetone | 45.41 | 45.41 | 45.43 | 45.41 | 45.43 |

| **Add** | **Etch Rertardation** | | | | |
|---|---|---|---|---|---|
| 5-aminotetrazole 0.0% | No | Yes | Yes | Yes | Yes |
| 5-aminotatrazole 0.10% | No | No | No | No | No |
| Adhesion | 50% | 90% | 85% | 88% | 83% |
| Finest line | 200 µm | 70 µm | 60 µm | 80 µm | 70 µm |
| 5-phenyltatrazole 0.10% | | No | No | No | No |
| Adhesion | 50% | 95% | 95% | 95% | 95% |
| Finest Line | 200 µm | 60 µm | 70 µm | 70 µm | 80 µm |
| Note: SMA550 is a alkyl maleate-styren copolymer available from the Monsanto Company, St Louis, MO. Reomet 42 is a polytriazole derivative available from Ciba-Geigy Corporation, Hawthrone, NY. TMPTA is trimethylolpropane triacrylate, available from Sartomer Company, Exton, PA. Adhesion is defined as the percentage of resist lines remaining on the panel after etching. Finest line held is defined as the smallest line remaining on the panel after etching. | | | | | |

In Table II, an experiment shows the effect of benzotriazole concentration on etching results. The samples were prepared and processed as in Example 1.

| | **Formulations (parts)** | | | | | |
|---|---|---|---|---|---|---|
| **Ingredient** | **comparative IIa** | **IIb** | **IIc** | **IId** | **IIe** | **IIf** |
| SMA640 | 35.00 | 35.00 | 35.00 | 35.00 | 35.00 | 35.00 |
| SR454 | 20.57 | 20.57 | 20.57 | 20.57 | 20.57 | 20.57 |
| tirbutyl citrate | 2.50 | 2.50 | 2.50 | 2.50 | 2.50 | 2.50 |
| BHT | 0.03 | 0.03 | 0.03 | 0.03 | 0.03 | 0.03 |
| DMPAP | 2.00 | 2.00 | 2.00 | 2.00 | 2.00 | 2.00 |
| EDB | 2.00 | 2.00 | 2.00 | 2.00 | 2.00 | 2.00 |
| ITX | 0.50 | 0.50 | 0.50 | 0.50 | 0.50 | 0.50 |
| Crystal violet dye | 0.40 | 0.40 | 0.40 | 0.40 | 0.40 | 0.40 |
| 2-butanone | 25.00 | 25.00 | 25.00 | 25.00 | 25.00 | 25.00 |
| methanol | 12.00 | 12.00 | 12.00 | 12.00 | 12.00 | 12.00 |
| benzotriazole | 0.0 | 0.01 | 0.02 | 0.04 | 0.08 | 0.16 |
| 5-aminotetrazole monohydrate | 0.04 | 0.04 | 0.04 | 0.04 | 0.04 | 0.04 |

| Measure | **Etching Results** | | | | | |
|---|---|---|---|---|---|---|
| Adhesion | 26% | 31% | 39% | 80% | 84% | 78% |
| Finest line held | 166 | 165 | 183 | 87 | 80 | 93 |
| Note: SMA640 - butyl maleate-styrene copolymer from Monsanto Company, St. Louis, MO. SR454 - trimethylolpropane polyoxyethylene triacrylate, available from Sartomer Company, Exton, PA. BHT- butylated hydroxy toluene, available from Shell Company, Houston, TX. DMPAP - dimethoxyphenyI acetophenone, available from Ciba Corporation, Hawthrone, NY. EDB - ethyl dimethylacetophenone, available from Aceto Corporation, Flushing, NY. ITX - isopropyl thioxanthone, available from Aceto Corporation, Flushing, NY. | | | | | | |

Although the invention has been described with reference to particular means, materials and embodiments, from the foregoing, one skilled in the art can easily ascertain the essential characteristics of the invention.

## Claims

1. A photopolymerizable composition comprising:
a tetrazole and a benzotriazole stain prone adhesion promoter; a polymeric binder; a multifunctional monomer; and a free radical photoinitiator.

2. The photopolymerizable composition of claim 1 further comprising a thermal addition inhibitor, a dye, and a plasticizer.

3. The photopolymerizable composition of claim 1 or 2 wherein tetrazole is present in the photopolymerizable composition in an amount of from about 0.001 to 1% by weight.

4. The photopolymerizable composition of claim 1, 2 or 3 wherein the composition comprises about 0.01 to 3% of the benzotriazole stain prone adhesion promotor, from about 10 to 60 parts by weight of a multifunctional monomer, from about 40 to 90 parts by weight of the binding agent, from about 0.001 to 10 parts by weight of a free radical initiator, and from 0.001 to 5 parts by weight of a thermal addition polymerization inhibitor.

5. The photopolymerizable composition of any of claims 1 to 4 wherein the tetrazole is selected from the group consisting of aryl, mercapto, alkyl, amine or substituted amine substituted tetrazoles and hydroxy substituted tetrazoles.

6. The photopolymerizable composition of any of claims 1 to 4 wherein the tetrazole comprises 5-aminotetrazole monohydrate.

7. The photopolymerizable composition of any of the preceding claims wherein the benzotriazole stain prone adhesion promoter is selected from the group consisting of benzotriazoles, derivatives thereof, and salts of benzotriazoles and benzotriazole derivatives.

8. The photopolymerizable composition of any of claims 1 to 6 wherein the benzotriazole stain-prone adhesion promoter is selected from benzotriazole; benzotriazole in which at least one hydrogen atom is substituted with an alkyl group, an aryl group, a nitro group, a halogen atom, an amino group, an hydroxyl group or a carboxyl group or in which the benzene ring has been substituted by a naphthalene ring; acid salts of benzotriazole and the aforesaid substituted benzotriazoles; and amine salts of benzotriazole and the aforesaid substituted benzotriazoles.

9. The photopolymerizable composition of any of claims 1 to 6 wherein the benzotriazole stain-prone adhesion promoter is selected from benzotriazole, benzotriazole hydrochloride, 1-chlorobenzotriazole, hydroxybenzotriazole, naphthotriazole, methylbenzotriazole and amine salts thereof.

10. A process for manufacturing a printed circuit board comprising the steps of:
(a) coating the photopolymerizable composition of any of the preceding claims onto a copper clad laminate;
(b) exposing the coating to a source of actinic radiation to form photopolymerized compositions; and
(c) removing the photopolymerized composition from the copper clad laminate.

11. The use of a tetrazole to reduce staining of copper cladding by a photopolymerizable composition containing a benzotriazole stain-prone adhesion promoter, a polymeric binder, a multifunctional monomer and a free-radical photoinitiator, wherein the said tetrazole is incorporated in the said photopolymerizable composition.

12. The use according to claim 11, wherein the photopolymerizable composition also contains a thermal addition inhibitor.

13. The use according to claim 11 or 12 wherein the benzotriazole stain-prone adhesion promoter is selected from the group consisting of benzotriazoles, derivatives thereof, and salts of benzotriazoles and benzotriazole derivatives.

14. The use according to claim 11 or 12, wherein the benzotriazole stain-prone adhesion promoter is selected from benzotriazole; benzotriazole in which at least one hydrogen atom is substituted with an alkyl group, an aryl group, a nitro group, a halogen atom, an amino group, an hydroxyl group or a carboxyl group or in which the benzene ring has been substituted by a naphthalene ring; acid salts of benzotriazole and the aforesaid substituted benzotriazoles; and amine salts of benzotriazole and the aforesaid substituted benzotriazoles.

15. The use according to claim 11 or 12, wherein the benzotriazole stain-prone adhesion promoter is selected from benzotriazole, benzotriazole hydrochloride, 1 - chlorobenzotriazole, hydroxybenzotriazole, naphthotriazole, methylbenzotriazole and amine salts thereof.

## Patentansprüche

1. Photopolymerisierbare Zusammensetzung, die ein Tetrazol und ein Benzotriazol als verfärbenden Haftvermittler, einen polymeren Binder, ein multifunktionales Monomer und ein freies Radikal als Photoinitiator aufweist.

2. Photopolymerisierbare Zusammensetzung nach Anspruch 1, die weiter einen zugesetzten thermischen Hemmstoff, einen Farbstoff und einen Weichmacher aufweist.

3. Photopolymerisierbare Zusammensetzung nach Anspruch 1 oder 2, wobei das Tetrazol in der photopolymerisierbaren Zusammensetzung in einer Menge von etwa 0,001 bis 1 Gewichtsprozent vorliegt.

4. Photopolymerisierbare Zusammensetzung nach Anspruch 1, 2 oder 3, wobei die Zusammensetzung etwa 0,01 bis 3 Gewichtsprozent des Benzotriazols als verfärbenden Haftvermittler, etwa 10 bis 60 Gewichtsteile des multifunktionalen Monomers, etwa 40 bis 90 Gewichtsteile des Bindemittels, etwa 0,001 bis 10 Gewichtsteile des freien Radikals als Initiator und etwa 0,001 bis 5 Gewichtsteile des zugesetzten thermischen Polymerisationshemmstoffs aufweist.

5. Photopolymerisierbare Zusammensetzung nach einem der Ansprüche 1 bis 4, wobei das Tetrazol aus der Gruppe von Aryl, Mercapto, Alkyl, Amin oder substituierten Amin-substituierten Tetrazolen und Hydroxy-substituierten Tetrazolen ausgewählt ist.

6. Photopolymerisierbare Zusammensetzung nach einem der Ansprüche 1 bis 4, wobei das Tetrazol 5-Aminotetrazol Monohydrat aufweist.

7. Photopolymerisierbare Zusammensetzung nach einem der vorhergehenden Ansprüche, wobei das Benzotriazol als verfärbender Haftvermittler aus der Gruppe von Benzotriazolen und Derivaten davon und Salzen von Benzotriazolen und Benzotriazolderivaten ausgewählt ist.

8. Photopolymerisierbare Zusammensetzung nach einem der Ansprüche 1 bis 6, wobei das Benzotriazol als verfärbender Haftvermittler aus Benzotriazol; Benzotriazol, in dem wenigstens ein Wasserstoffatom ersetzt ist durch eine Alkylgruppe, eine Arylgruppe, eine Nitrogruppe, ein Halogenatom, eine Aminogruppe, eine Hydroxylgruppe oder eine Carboxylgruppe oder in dem der Benzenering durch einen Naphtalenring substituiert worden ist; Salzen von Benzotriazol und den oben genannten substituierten Benzotriazolen; und Aminsalzen von Benzotriazol und den oben genannten substituierten Benzotriazolen ausgewählt ist.

9. Photopolymerisierbare Zusammensetzung nach einem der Ansprüche 1 bis 6, wobei das Benzotriazol als verfärbender Haftvermittler aus Benzotriazol, Benzotriazolhydrochlorid, 1-Chlorobenzotriazol, Hydroxybenzotriazol, Naphtotriazol, Methylbenzotriazol und Aminsalzen davon ausgewählt ist.

10. Verfahren zum Herstellen einer gedruckten Leiterplatte, das die Schritte von
a) Auftragen einer Schicht der photopolymerisierbaren Zusammensetzung nach einem der vorhergehenden Ansprüche auf ein mit Kupfer plattiertes Laminat;
b) Aussetzen der Schicht einer Quelle chemisch wirksamer Strahlung, um photopolymerisierte Zusammensetzungen zu bilden; und
c) Entfernen der photopolymerisierten Zusammensetzung von dem mit Kupfer plattierten Laminat.
aufweist.

11. Verwendung eines Tetrazols, um die Fleckenbildung auf plattiertem Kupfer durch eine photopolymerisierbare Zusammensetzung zu verringern, die ein Benzotriazol als verfärbenden Haftvermittler, einen polymerischen Binder, ein multifunktionales Monomer und ein freies Radikal als Photoinitiator aufweist, wobei dieses Tetrazol in dieser photopolymerisierbaren Zusammensetzung aufgenommen ist.

12. Verwendung nach Anspruch 1, wobei die photopolymerisierbare Zusammensetzung auch einen zugesetzten thermischem Hemmstoff aufweist.

13. Verwendung nach Anspruch 11 oder 12, wobei das Benzotriazol als verfärbender Haftvermittler aus der Gruppe von Benzotriazolen, Derivaten davon, und Salzen von Benzotriazolen und Benzotriazolderivaten ausgewählt ist.

14. Verwendung nach Anspruch 11 oder 12, wobei das Benzotriazol als verfärbender Haftvermittler aus Benzotriazol; Benzotriazol, in dem wenigstens ein Wasserstoffatom ersetzt ist durch eine Alkylgruppe, eine Arylgruppe, eine Nitrogruppe, ein Halogenatom, eine Aminogruppe, eine Hydroxylgruppe oder eine Carboxylgruppe oder in dem der Benzenering durch einen Naphtalenring substituiert worden ist; Salzen von Benzotriazol und den oben genannten substituierten Benzotriazolen; und Aminsalzen von Benzotriazol und den oben genannten substituierten Benzotriazolen ausgewählt ist.

15. Verwendung nach Anspruch 11 oder 12, wobei das Benzotriazol als verfärbender Haftvermittler aus Benzotriazol, Benzotriazolhydrochlorid, 1-Chlorobenzotriazol, Hydroxybenzotriazol, Naphtotriazol, Methylbenzotriazol und Aminsalzen davon ausgewählt ist.

## Revendications

1. Composition photopolymérisable comprenant :
un tétrazole et un promoteur d'adhésion sujet aux taches de type benzotriazole; un liant polymère; un monomère multifonctionnel; et un photoinitiateur de radicaux libres.

2. Composition photopolymérisable selon la revendication 1 comprenant, en outre, un inhibiteur d'addition thermique, un colorant, et un plastifiant.

3. Composition photopolymérisable selon la revendication 1 ou 2, le tétrazole étant présent dans la composition photopolymérisable en une quantité d'environ 0,001 à 1% en poids.

4. Composition photopolymérisable selon la revendication 1, 2 ou 3, la composition comprenant environ 0,01 à 3% du promoteur d'adhésion sujet aux taches de type benzotriazole, environ 10 à 60 parties en poids d'un monomère multifonctionnel, environ 40 à 90 parties en poids de l'agent liant, environ 0,001 à 10 parties en poids d'un initiateur de radicaux libres, et 0,001 à 5 parties en poids d'un inhibiteur de polymérisation par addition thermique.

5. Composition photopolymérisable selon l'une quelconque des revendications 1 à 4 dans laquelle le tétrazole est choisi dans le groupe constitué des tétrazoles à substitution aryle, mercapto, alkyle, amino ou amino substitué et des tétrazoles à substitution hydroxy.

6. Composition photopolymérisable selon l'une quelconque des revendications 1 à 4 dans laquelle le tétrazole comprend du 5-aminotétrazole monohydraté.

7. Composition photopolymérisable selon l'une quelconque des revendications précédentes dans laquelle le promoteur d'adhésion sujet aux taches de type benzotriazole est choisi dans le groupe constitué des benzotriazoles, des dérivés de ceux-ci, et des sels de benzotriazoles et de dérivés de benzotriazoles.

8. Composition photopolymérisable selon l'une quelconque des revendications 1 à 6 dans laquelle le promoteur d'adhésion sujet aux taches de type benzotriazole est choisi parmi le benzotriazole; un benzotriazole dans lequel au moins un atome d'hydrogène est remplacé par un groupe alkyle, un groupe aryle, un groupe nitro, un atome d'halogène, un groupe amino, un groupe hydroxyle ou un groupe carboxyle ou dans lequel le noyau benzénique a été remplacé par un noyau naphtalénique; les sels d'acide du benzotriazole et des benzotriazoles substitués susmentionnés; et les sels d' amine du benzotriazole et des benzotriazoles substitués susmentionnés.

9. Composition photopolymérisable selon l'une quelconque des revendications 1 à 6 dans laquelle le promoteur d'adhésion sujet aux taches est choisi parmi le benzotriazole, le chlorhydrate de benzotriazole, le 1-chlorobenzotriazole, l'hydroxybenzotriazole, le naphtotriazole, le méthylbenzotriazole et leurs sels d'amine.

10. Procédé pour fabriquer une plaquette à circuits imprimés comprenant les étapes consistant à :
(a) appliquer la composition photopolymérisable selon l'une quelconque des revendications précédentes sur un stratifié plaqué de cuivre;
(b) exposer le revêtement à une source de rayonnement actinique pour former des compositions photopolymérisées; et
(c) enlever la composition photopolymérisée du stratifié plaqué de cuivre.

11. Utilisation d'un tétrazole pour diminuer le maculage d'un placage de cuivre par une composition photopolymérisable contenant un promoteur d'adhésion sujet aux taches de type benzotriazole, un liant polymère, un monomère multifonctionnel et un photoinitiateur de radicaux libres, dans laquelle ledit tétrazole est incorporé dans ladite composition photopolymérisable.

12. Utilisation selon la revendication 11, dans laquelle la composition photopolymérisable contient aussi un inhibiteur d'addition thermique.

13. Utilisation selon la revendication 11 ou 12 dans laquelle le promoteur d'adhésion sujet aux taches de type benzotriazole est choisi dans le groupe constitué des benzotriazoles, des dérivés de ceux-ci, et des sels de benzotriazoles et de dérivés de benzotriazoles.

14. Utilisation selon la revendication 11 ou 12, dans laquelle le promoteur d'adhésion sujet aux taches de type benzotriazole est choisi parmi le benzotriazole; un benzotriazole dans lequel au moins un atome d'hydrogène est remplacé par un groupe alkyle, un groupe aryle, un groupe nitro, un atome d'halogène, un groupe amino, un groupe hydroxyle ou un groupe carboxyle ou dans lequel le noyau benzénique a été remplacé par un noyau naphtalénique; les sels d'acide du benzotriazole et des benzotriazoles substitués susmentionnés; et les sels d'amine du benzotriazole et des benzotriazoles substitués susmentionnés.

15. Utilisation selon la revendication 11 ou 12, dans laquelle le promoteur d'adhésion sujet aux taches de type benzotriazole est choisi parmi le benzotriazole, le chlorhydrate de benzotriazole, le 1-chlorobenzotriazole, l'hydroxybenzotriazole, le naphtotriazole, le méthylbenzotriazole et leurs sels d'amine.
